# EUROPEAN PATENT APPLICATION

(11) **EP 1 868 037 A1**
(43) Date of publication of application: **19.12.2007**
(21) Application number: 06729964.4
(22) Date of filing: 24.03.2006
(51) Int. Cl.: G03F 7/38, B41N 1/14, B41N 3/00, G03F 7/00, G03F 7/16

(54) **PRODUCTION METHOD AND HANDLING METHOD OF ORIGINAL PLATE OF PLANOGRAPHIC PRINTING PLATE**

(30) Priority: 25.03.2005 JP 2005089959
(71) Applicant: FUJIFILM Corporation, Minato-ku Tokyo 106-8620 (JP)
(72) Inventor: OSHIMA, Atsushi c/o FUJIFILM Corporation, Haibara-gun, Shizuoka, 4210302 (JP); AOSHIMA, Norio c/o FUJIFILM Corporation, Haibara-gun, Shizuoka, 4210302 (JP)
(74) Representative: HOFFMANN EITLE
(86) International application number: PCT/JP2006/306016
(87) International publication number: WO 2006/101207

(57) **Abstract**

A planographic printing plate precursor which prevents deformation and destruction of fine particles dispersed in an image forming layer thereof and has high developing performance and a high speed thin layer coating aptitude is provided. A method for producing and handling a planographic printing plate precursor having an image forming layer containing a photosensitive composition having fine particles dispersed therein is provided. The pressure acting on the image forming layer during or after formation of the image forming layer is 1.5 × 10⁵ N/m² or less. The pressure conditions are achieved by controlling any one of the pressure PL, which acts on the coating liquid during formation of the image forming layer, the sum of the PL and shear stress τ, the pressure PF, which acts at the time of transfer of the support after formation of the image forming layer, the pressure PR, which acts at the time of winding the long strip support, the pressure PP, which acts at the time of stacking the sheets of the planographic printing plate precursor, and the pressure PK, which acts at the time of storing the stock roll of the planographic printing plate precursor. The fine particles are preferably polymer fine particles.

## Description

### Technical Field

The invention relates to a method for producing a planographic printing plate precursor, including applying a coating liquid containing a photosensitive composition having fine particles dispersed therein onto a support and drying the coating liquid to form an image forming layer, and a method for handling the planographic printing plate precursor.

### Background Art

While planographic printing plates were conventionally produced by exposing planographic printing plate precursors to light through a lith film which is an intermediate material, the production process of a planographic printing plate is shifting to a CTP system, in which data is inputted to and digitized in a computer and then directly outputted, in accordance with the rapid development of digitization in the printing field of recent years. In addition, in order to further simplify the process, a development-free planographic printing plate precursor has been studied, the precursor being serviceable for printing immediately after light exposure without requiring development treatment.

One example of methods for reducing steps of the treatment process is a so-called on-machine development method, in which an exposed planographic printing plate precursor is mounted on a cylinder in a printing machine, and the non-image areas on the planographic printing plate precursor are removed by ink and dampening water supplied while the cylinder is rotated. More specifically, an exposed planographic printing plate precursor is mounted on a printing machine without any special treatment, and developed by a common printing process. Planographic printing plate precursors suitable for on-machine development must have an image forming layer (heat-sensitive layer) soluble in dampening water or an ink solvent, and handling property suitable for development on a printing machine placed in a bright room.

For example, Patent Document 1 describes a planographic printing plate precursor composed of a hydrophilic support having thereon a photosensitive layer containing thermoplastic hydrophobic polymer fine particles dispersed in a hydrophilic binder polymer. Patent Document 1 describes that the planographic printing plate precursor is subjected to laser exposure to cause thermal coalescence of thermoplastic hydrophobic polymer particles in the image forming layer thereby forming an image, subsequently the precursor is mounted on the cylinder in the printing machine, where the unexposed areas are removed by dampening water and/or ink; in other words, the planographic printing plate precursor is useful for on-machine development. The planographic printing plate precursor is sensitive to infrared light, so that it provides bright room handleability.

In addition, Patent Documents 2 to 6 describe production of a printing plate by thermal coalescence of thermoplastic fine particles, followed by on-machine development.

Patent Document 7 describes that good on-machine developability, high sensitivity, and high printing durability are provided by a planographic printing plate precursor having an image forming layer containing at least one of thermoplastic polymer fine particles, polymer fine particles having heat-reactive groups, and microcapsules containing a heat-reactive group-containing compound.

Patent Document 8 describes that good printing durability is provided by a heat-sensitive planographic printing plate precursor of on-machine development type having an image forming layer composed of microcapsules containing a vinyloxy group-containing compound, a hydrophilic resin, and an acid precursor.

Patent Document 9 describes that good printing durability is provided by a heat-sensitive planographic printing plate precursor of on-machine development type having an image forming layer composed of microcapsules containing an epoxy group-containing compound, a hydrophilic resin, and an acid precursor.

Patent Document 10 describes that good printing durability is provided by a heat-sensitive planographic printing plate precursor of on-machine development type having an image forming layer composed of microcapsules containing a radical-polymerizable group-containing compound, a hydrophilic resin, and a heat-sensitive polymerization initiator.

Patent Document 11 describes a planographic printing plate precursor having a photosensitive layer containing lipophilic polymer fine particles dispersed in a hydrophilic polymer matrix, wherein the light absorbing agent contained in the photosensitive layer converts light supplied by photoirradiation into heat, the heat causes foaming, heat fusion, and the like of the lipophilic polymer, thus the photosensitive layer loses hydrophilicity to have compatibility with ink, and these actions are used for the development of the precursor.

Patent Document 11 describes application of a coating liquid containing a photosensitive composition by a known application method onto a support to form a photosensitive layer, wherein the pressure acting on the coating liquid applied on the surface of the support is limited to below 0.5 × 10⁵ N/m² thereby preventing aggregation of polymer particles, and effectively correcting unevenness of the diameter and degree of dispersion of polymer particles in the photosensitive layer to prevent image voids or bleeding after light exposure.

As described in Patent Document 11, when a coating liquid containing a photosensitive composition having fine particles dispersed therein is applied onto a support and dried to form an image forming layer, aggregation of the fine particles in the coating liquid during the coating process can be prevented by limiting the pressure acting on the coating liquid (liquid pressure) in the puddle formed between the support and the coating member, such as a coating head used for an extrusion coating method, to a sufficiently low level (for example, below 0.5 × 10⁵ N/m²)
Patent Document 1: Japanese Patent No. 2938397
Patent Document 2: Japanese Patent Application Laid-Open (JP-A) No. 9-127683
Patent Document 3: JP-A No. 9-123387
Patent Document 4: JP-A No. 9-123388
Patent Document 5: JP-A No. 9-131850
Patent Document 6: Pamphlet of WO 99/10186
Patent Document 7: JP-ANo. 2001-293971
Patent Document 8: JP-A No. 2002-29162
Patent Document 9: JP-ANo. 2002-46361
Patent Document 10: JP-A No. 2002-137562
Patent Document 11: JP-A No. 2004-292264

### Disclosure of the Invention

### Problems to be Solved by the Invention

However, during the formation of an image forming layer by applying a coating liquid containing a photosensitive composition having fine particles dispersed therein and then drying the coating liquid, in cases where the coating liquid is continuously applied onto a support such as an aluminum web by a known coating method such as a coating slide bead coating method, an extrusion coating method, a curtain coating method, a wire bar coating method, or a gravure coating method, if the pressure acting on the coating liquid is too low during the application onto the support, a desired high speed thin layer coating aptitude cannot be achieved. The "high speed thin layer coating aptitude" herein means a property of allowing stable application of a coating quantity of, for example, 25 cc/m² or less at a line speed of 60 m/min or more.

On the other hand, in cases where the coating liquid is continuously applied onto a support such as an aluminum web by a known coating method, if the pressure acting on the coating liquid is too high during the application onto the support, as described above, fine particles are deformed or destroyed, which results in the deterioration of the developing performance of the planographic printing plate precursor such as on-machine developability.

As to the planographic printing plate precursor having an image forming layer formed by applying a coating liquid containing a photosensitive composition having fine particles dispersed therein onto a support, and then drying the coating liquid, even after the application and drying of the coating liquid, the fine particles dispersed in the image forming layer can be deformed or destroyed if an excessive pressure is exerted on the image forming layer on the support during transfer of the support having the image forming layer or winding of the support having the image forming layer into a stock roll of the planographic printing plate precursor. This results in the deterioration of the developing performance of the planographic printing plate precursor.

In addition, even after the support having the image forming layer has been cut into a predetermined product size to produce a final planographic printing plate precursor, the fine particles dispersed in the image forming layer can be deformed or destroyed if an excessive pressure is exerted on the image forming layer on the support, which results in the deterioration of the developing performance of the planographic printing plate precursor.

In consideration of the above problems, the invention provides a production method for a planographic printing plate precursor which provides a desired high speed thin layer coating aptitude during application of a coating liquid containing dispersed fine particles onto a support, and prevents deformation and destruction of the fine particles.

The invention also provides a method for handling a planographic printing plate precursor which prevents deformation and destruction of the fine particles dispersed in the image forming layer after the completion of the production of the planographic printing plate precursor.

### Means for Solving Problems

The invention provides a method for producing and handling a planographic printing plate precursor, comprising: applying, onto a support, a coating liquid comprising a photosensitive composition having fine particles dispersed therein by using a coating member; and drying the coating liquid to form an image forming layer, wherein a pressure acting on the image forming layer during or after formation of the image forming layer is 1.5 × 10⁵ N/m² or less.

More specifically, the invention provides a method for producing a planographic printing plate precursor, comprising: applying, onto a support, a coating liquid comprising a photosensitive composition having fine particles dispersed therein by using a coating member; and drying the coating liquid to form an image forming layer, wherein PL, which is a pressure acting on the coating liquid intervening between the coating member and the support during application of the coating liquid, is at least 0.5 × 10⁵ N/m² and less than 1.5 × 10⁵ N/m².

The invention also provides a method for producing a planographic printing plate precursor, comprising: applying, onto a support, a coating liquid comprising a photosensitive composition having fine particles dispersed therein by using a coating member; and drying the coating liquid to form an image forming layer, wherein the sum of the pressure PL and a shear stress τ during the application of the coating liquid is at least 0.5 × 10⁵ N/m² and 1.5 × 10⁵ N/m² or less.

The invention also provides a method for producing a planographic printing plate precursor, comprising: applying, onto a support, a coating liquid comprising a photosensitive composition having fine particles dispersed therein by using a coating member; and drying the coating liquid to form an image forming layer, further comprising transferring the support having the image forming layer formed thereon, and PF, which is a pressure acting on the image forming layer during the transfer of the support, is 1.5 × 10⁵ N/m² or less.

The invention also provides a method for producing a planographic printing plate precursor, comprising: applying, onto a support, a coating liquid comprising a photosensitive composition having fine particles dispersed therein by using a coating member; and drying the coating liquid to form an image forming layer, further comprising winding the support, which is in the form of a long strip, together with the image forming layer into a stock roll and winding off the support from the stock roll so as to cut the support together with the image forming layer, wherein the support is wound into a roll in such a manner that PR, which is a pressure acting on the image forming layer on the support forming the stock roll during the winding of the support, is 1.5 × 10⁵ N/m² or less.

The invention also provides any one of the above-described methods for producing a planographic printing plate precursor, wherein the coating liquid comprises polymer fine particles dispersed therein.

The invention also provides a method for handling a planographic printing plate precursor formed by a method comprising applying, onto a support, a coating liquid comprising a photosensitive composition having fine particles dispersed therein by using a coating member, and drying the coating liquid to form an image forming layer, wherein the method for handling comprises stacking a plurality of sheets of the planographic printing plate precursor, and wherein PP, which is a pressure acting on the image forming layer on the planographic printing plate precursor during the stacking, is 1.5 × 10⁵ N/m² or less.

The invention also provides a method for handling a planographic printing plate precursor formed by a method comprising applying, onto a support, a coating liquid comprising a photosensitive composition having fine particles dispersed therein by using a coating member, and drying the coating liquid to form an image forming layer, wherein the method for handling comprises winding the support, which is in the form of a long strip, together with the image forming layer into a stock roll and storing the stock roll, and wherein PK, which is a pressure acting on the image forming layer on the support forming the stock roll during the storing, is 1.5 × 10⁵ N/m² or less.

The invention also provides any one of the above-described methods for handling a planographic printing plate precursor, wherein the coating liquid comprises polymer fine particles dispersed therein

### Effect of the Invention

According to the method for producing a planographic printing plate precursor of the invention, a desired high speed thin layer coating aptitude is provided during application of a coating liquid containing dispersed fine particles onto a support, and deformation and destruction of the fine particles can be prevented.

According to the method for handling a planographic printing plate precursor of the invention, deformation and destruction of the fine particles dispersed in the image forming layer can be prevented after completion of the production of the planographic printing plate precursor.

### Brief Description of the Drawing

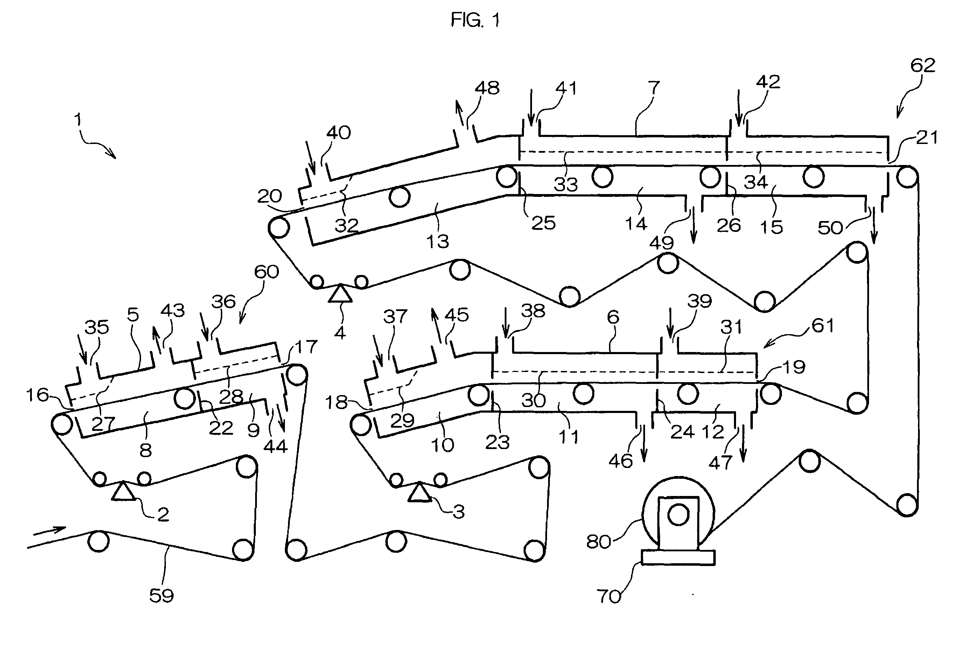

Fig. 1 is a schematic diagram showing a schematic structure of a production line for the method for producing a planographic printing plate precursor according to an embodiment of the invention.

### Best Mode for Carrying Out the Invention

The production method and the handling method for a planographic printing plate precursor of the invention are further described below.

### Method for producing a planographic printing plate precursor

### Production line for a planographic printing plate precursor

Fig. 1 shows a production line for a planographic printing plate precursor according to an embodiment of the invention. At the upper end of the production line 1, a device (not shown) for transmitting an aluminum web 59, which serves as the support, is disposed, the transmitting device sending an aluminum web 59 having a thickness of 0.1 to 0.6 mm downstream at a traveling speed corresponding to the speed of producing the planographic printing plate in the production line 1. The production line 1 also has plural transfer rollers along the traveling path for the aluminum web 59, wherein the aluminum web 59 is guided by the plural transfer rollers so as to travel downstream via the transfer rollers at a predetermined speed subjected to the transfer force of the transfer motor (not shown). Transfer rollers 51 to 57 are disposed along the traveling path, the rollers contacting with coated surfaces such as an undercoat layer, image forming layer, or overcoat layer.

In the production line 1, in the first place, the shape of the aluminum web 59 transmitted downstream by the transmitting device is corrected by a correcting device (not shown) such as a roller leveler or tension leveler to sufficiently flatten the aluminum web 59. Subsequently, before roughening treatment (not shown) of the aluminum web 59, degreasing treatment (not shown) may be optionally conducted to remove the rolling oil on the surface of the aluminum web 59 using, for example, a surfactant, organic solvent, or aqueous alkaline solution. The roughening treatment of the aluminum plate surface may be conducted by any methods, and examples thereof include a method including mechanically roughening the surface, a method including electrochemically dissolving the surface for roughening, and a method including chemically and selectively dissolving the surface.

Examples of the mechanical method include known methods such as a ball polishing method, a brush polishing method, a blast polishing method, or a buff polishing method. Examples of the electrochemical roughening method include a method of treating the surface in an electrolytic solution of hydrochloric acid or nitric acid under an alternating current or direct current. Alternatively, as disclosed in JP-A No. 54-63902, a roughening method including a combination of a mechanical method and an electrochemical method may be used. The aluminum web 59 roughened by any one of these methods, which may be further subjected to alkali etching treatment and neutralization treatment if necessary, may be then subjected to an anodization treatment to improve the water retentivity or abrasion resistance of the surface if desired. Examples of the electrolyte used for the anodization treatment of the aluminum web 59 include various electrolytes which can form a porous oxide film, and specific examples thereof include a sulfuric acid, a phosphoric acid, an oxalic acid, a chromic acid, and mixed acids of any of these. The concentration of the electrolyte in the electrolytic solution is appropriately selected according to the kind of the electrolyte.

While the condition for the anodization treatment cannot be specified because they vary according to the electrolyte to be used, it is generally regarded as follows. Concentration of the electrolyte: 1 to 80 wt%; liquid temperature: 5 to 70°C; current density: 5 to 60 A/dm²; voltage: 1 to 100V; and electrolysis time: 10 seconds to 5 minutes. If the amount of the anode oxide film is less than 1.0 g/m², problems such as insufficient printing durability or tendency of being scratched on non-image areas on the planographic printing plate to attract ink during printing, which results in so-called "scratch stains", may occur. Following the anodization treatment, the aluminum surface may be further subjected to hydrophilizing treatment as necessity. Examples of the hydrophilizing treatment for use in the invention include an alkali metal silicate (for example, aqueous sodium silicate solution) method as disclosed in U.S. Patent Nos. 2,714,066, 3,181,461, 3,280,734, and 3,902,734. Under theese methods, the support is immersed or electrolyzed in an aqueous sodium silicate solution. Examples of the hydrophilizing treatment further include a treatment with potassium fluorozirconate as disclosed in Japanese Patent Application Publication (JP-B) No. 36-22063, and a treatment with polyvinylphosphonic acid as disclosed in U.S. Patent Nos.3,276,868, 4,153,461, and 4,689,272.

Subsequently, an undercoat layer, an image forming layer, and an overcoat layer are formed on the aluminum web 59 by application and drying.

In the production line 1, as shown in Fig. 1, a coating device 2 for applying the undercoat layer onto the aluminum web 59 is disposed at the downstream side of the anodization device, the coating device 2 applying an undercoat layer coating liquid onto the roughened surface of the aluminum web to form an undercoat layer.

Examples of the method for applying the undercoat layer coating liquid onto the aluminum web 59 include various known methods, and specific examples thereof include a slide bead coating method, an extrusion coating method, a curtain coating method, a wire bar coating method, and a gravure coating method.

In the production line 1, a hot-air drying device 60 as a heating unit is disposed at the downstream side of the coating device 2. In the hot-air drying device 60, a drying furnace 5 having an explosion-proof and insulating structure is provided in the form of a long slender casing along the traveling direction of the aluminum web 59. Plural supporting rolls are disposed in the drying furnace 5 along the traveling path of the aluminum web 59.

The drying furnace 5 has openings 16 and 17 on the end surfaces at the upstream and downstream sides, respectively, along the traveling direction of the aluminum web 59. Through the openings 16 and 17, the aluminum web 59 enters into and exits from the drying furnace 5, respectively. The aluminum web 59 fed from the opening 16 into the drying furnace 5 travels within the drying furnace 5 with its back side supported by the supporting rolls, and gets out of the drying furnace 5 from the opening 17. The drying furnace 5 also has therein a diaphragm 22 for partitioning the drying furnace 5 between a heating chamber 8 on the upstream side and a heating chamber 9 on the downstream side, the diaphragm 22 preventing the movement of air currents between the heating chambers 8 and 9.

The heating chamber 8 on the upstream side has an air inlet port 35 and an air exit port 43. A hot-air generator (not shown) is connected to the air inlet port 35 through a duct or the like. A current plate 27 is disposed in the heating chamber 8 in opposition to the air inlet port 35. The current plate 27 has plural slit outlets. The current plate 27 rectifies hot air fed from the air inlet port 35 into the heating chamber 8 to hot air currents (hot air) flowing along the surface of the aluminum web 59.
At that time, hot air is fed to the air inlet port 35 at a rate of 50 to 100 m³/minute for 1 m of width of the aluminum web 59, the temperature of the hot air being adjusted to 50 to 150°C. Through the temperature control, in the heating chamber 8, about 80% of the organic solvent contained in the photosensitive coating layer applied onto the aluminum web 59 evaporates, and thus the photosensitive coating layer turns into a soft film.

The heating chamber 9 on the downstream side also has an air inlet port 36 and an air exit port 44. A hot-air generator (not shown) is connected to the air inlet port 36 through a duct or the like. A current plate 28 is disposed in the heating chamber 9 between the air inlet port 36 and the aluminum web 59. The current plate 28 has plural slit outlets. The current plate 28 rectifies hot air fed from the air inlet port 36 into the heating chamber 9 to hot air currents (hot air) blowing generally perpendicular to the surface of the aluminum web 59.
At that time, hot air is fed to the air inlet port 36 at a rate of 50 to 100 m³/minute for 1 m of width of an aluminum plate 12, the temperature of the hot air being adjusted to 80 to 150°C. Through the temperature control, in the heating chamber 9, about 95% or more of the organic solvent contained in the photosensitive coating layer applied onto the aluminum web 59 evaporates, and thus the photosensitive coating layer in a soft film state turns into a tack-free state.

A coating device 3 for applying the image forming layer onto the aluminum web 59 is disposed at the downstream side of the undercoat layer drying furnace, the coating device 3 applying an image forming layer coating liquid onto the surface of the aluminum web 59 coated with the undercoat layer to form an image forming layer. Application of the image forming layer coating liquid onto the aluminum web 59 may employ the same method as listed for the application of the undercoat layer. When the image forming layer coating liquid is applied onto the aluminum web 59, the sum of the pressure PL and shear stress τ acting on the image forming layer coating liquid in the puddle formed between the aluminum web 59 and the coating member, such as a coating head used for an extrusion coating method, is preferably from 0.5 × 10⁵ N/m² or more to 1.5 × 10⁵ N/m² or less.

Examples of the effective method for reducing the sum of the pressure PL and the shear stress τ include the reduction of the tension of the aluminum web 59 in the coating position, the reduction in the viscosity of the image forming layer coating liquid, and the reduction of the transfer speed of the aluminum web 59. More specifically, the sum of the pressure PL and the shear stress τ is reduced by reducing at least one of the tension of the aluminum web 59, the viscosity of the image forming layer coating liquid, and the transfer speed of the aluminum web 59. In cases where the image forming layer coating liquid is applied with a coating member in contact with the aluminum web 59, such as a wire bar coating method, roll coating method, or gravure coating method, the pressure PL is effectively reduced by the enlargement of the outside diameter (radius of curvature) of the surface of the coating member (bar, roll, or gravure roll) in contact with the aluminum web 59, or the approximation of the linear velocity of the coating member (roll or gravure roll) to the transfer speed of the aluminum web 59 with the coating member rotated toward the driven direction of the aluminum web 59.

On the other hand, the sum of the pressure PL and the shear stress τ is increased by, contrary to the reduction of the sum, increasing at least one of the tension of the aluminum web 59, the viscosity of the image forming layer coating liquid, and the transfer speed of the aluminum web 59.

A hot-air drying device 61 as a heating unit is disposed at the downstream side of the coating device 3. In the hot-air drying device, a drying furnace 6 having an explosion-proof and insulating structure is provided in the form of a long slender casing along the traveling direction of the aluminum web 59. Plural supporting rolls are disposed in the drying furnace 6 along the traveling path of the aluminum web 59.
The drying furnace 6 has openings 18 and 19 on the end surfaces at the upstream and downstream sides, respectively, along the traveling direction of the aluminum web 59. Through the openings 18 and 19, the aluminum web 59 enters into and exits from the drying furnace 6, respectively. The aluminum web 59 fed from the opening 18 into the drying furnace 6 travels within the drying furnace 6 with its back side supported by the supporting rolls, and gets out of the drying furnace 6 from the opening 19. The drying furnace 6 also has therein diaphragms 23 and 24 for partitioning the drying furnace 6 between a heating chamber 10 on the upstream side and heating chambers 11 and 12 on the downstream side, the diaphragms 23 and 24 preventing the movement of air currents between the heating chambers 10, 11, and 12.

The heating chamber 10 on the upstream side has an air inlet port 37 and an air exit port 45. A hot-air generator (not shown) is connected to the air inlet port 37 through a duct or the like. A current plate 29 is disposed in the heating chamber 10 in opposition to the air inlet port 37. The current plate 29 has plural slit outlets. The current plate 29 rectifies hot air fed from the air inlet port 37 into the heating chamber 10 to hot air currents (hot air) flowing along the surface of the aluminum web 59.
At that time, hot air is fed to the air inlet port 37 at a rate of 50 to 100 m³/minute for 1 m of width of the aluminum web 59, the temperature of the hot air being adjusted to 50 to 150°C. Through the temperature control, in the heating chamber 10, about 80% of the organic solvent contained in the image forming layer applied onto the aluminum web 59 evaporates, and thus the photosensitive coating layer turns into a soft film.
The heating chamber 11 on the downstream side also has an air inlet port 38 and an air exit port 46. A hot-air generator (not shown) is connected to the air inlet port 38 through a duct or the like. A current plate 30 is disposed in the heating chamber 11 between the air inlet port 38 and the aluminum web 59. The current plate 30 has plural slit outlets. The current plate 30 rectifies hot air fed from the air inlet port 37 into the heating chamber 11 to hot air currents (hot air) blowing generally perpendicular to the surface of the aluminum web 59.

At that time, hot air is fed to the air inlet port 38 at a rate of 50 to 100 m³/minute for 1 m of width of the aluminum web 59, the temperature of the hot air being adjusted to 80 to 150°C. Through the temperature control, in the heating chamber 11, about 95% or more of the organic solvent contained in the photosensitive coating layer applied onto the aluminum web 59 evaporates, and thus the photosensitive coating layer in a soft film state turns into a tack-free state.

A heating chamber 12 at the lower end has a similar structure to the heating chamber 11, but as necessary, may be used as a cooling furnace. The heating chamber 12 has an air inlet port 39 and an air exit port 47. A hot-air generator (not shown) is connected to the air inlet port 39 through a duct or the like. A current plate 31 is disposed in the heating chamber 12 between the air inlet port 39 and the aluminum web 59. The current plate 31 has plural slit outlets. The current plate 31 rectifies hot air fed from the air inlet port 39 into the heating chamber 12 to cold or hot air currents (cold or hot air) blowing generally perpendicular to the surface of the aluminum web 59.
At that time, hot air is fed to the air inlet port 39 at a rate of 50 to 100 m³/minute for 1 m of width of the aluminum web 59, the temperature of the hot air being adjusted to 25 to 150°C. Through the temperature control, in the heating chamber 12, the temperature on the surface of the image forming layer on the aluminum web 59 may be cooled to 100°C or lower, and about 95% or more of the organic solvent contained in the image forming layer applied onto the aluminum web 59 may evaporate, and thus the image forming layer turns into a tack-free state.

In the production line 1, a coating device 4 for applying the overcoat layer coating liquid is disposed at the downstream side of the drying device 61. In the production line 1, an overcoat layer is optionally formed for oxygen barrier and other purposes at the downstream side of the drying furnace 6 by applying PVA (polyvinyl alcohol), swelling mica, or the like using the coating device 4 onto the image forming layer. Application of the overcoat layer coating liquid onto the aluminum web 59 may employ the same method as listed for the application of the undercoat layer. A hot-air drying device 62 as a heating unit is disposed at the downstream side of the coating device 4. In the hot-air drying device 62, a drying furnace 7 having an explosion-proof and insulating structure is provided in the form of a long slender casing along the traveling direction of the aluminum web 59. Plural supporting rolls are disposed in the drying furnace 7 along the traveling path of the aluminum web 59.
The drying furnace 7 has openings 20 and 21 on the end surfaces at the upstream and downstream sides, respectively, along the traveling direction of the aluminum web 59. Through the openings 20 and 21, the aluminum web 59 enters into and exits from the drying furnace 7, respectively. The aluminum web 59 fed from the opening 20 into the drying furnace 7 travels within the drying furnace 5 with its back side supported by the supporting rolls, and gets out of the drying furnace 7 from the opening 21. The drying furnace 7 also has therein diaphragms 25 and 26 for partitioning the drying furnace 7 between a heating chamber 13 on the upstream side and heating chambers 14 and 15 on the downstream side, the diaphragms 25 and 26 preventing the movement of air currents between the heating chambers 13, 14, and 15.

The heating chamber 14 on the upstream side has an air inlet port 40 and an air exit port 48. A hot-air generator (not shown) is connected to the air inlet port 40 through a duct or the like. A current plate 32 is disposed in the heating chamber 13 in opposition to the air inlet port 40. The current plate 32 has plural slit outlets. The current plate 32 rectifies hot air fed from the air inlet port 40 into the heating chamber 13 to hot air currents (hot air) flowing along the surface of the aluminum web 59.
At that time, hot air is fed to the air inlet port 40 at a rate of 50 to 100 m³/minute for 1 m of width of the aluminum web 59, the temperature of the hot air being adjusted to 50 to 150°C. Through the temperature control, in the heating chamber 13, about 80% of the organic solvent contained in the overcoat layer applied onto the aluminum web 59 evaporates, and thus the overcoat layer turns into a soft film.

The heating chamber 14 on the downstream side also has an air inlet port 41 and an air exit port 49. A hot-air generator (not shown) is connected to the air inlet port 41 through a duct or the like. A current plate 33 is disposed in the heating chamber 14 between the air inlet port 41 and the aluminum web 59. The current plate 33 has plural slit outlets. The current plate 33 rectifies hot air fed from the air inlet port 41 into the heating chamber 14 to hot air currents (hot air) blowing generally perpendicular to the surface of the aluminum web 59.
At that time, hot air is fed to the air inlet port 41 at a rate of 50 to 100 m³/minute for 1 m of width of the aluminum web 59, the temperature of the hot air being adjusted to 80 to 150°C. Through the temperature control, in the heating chamber 14, about 95% or more of the organic solvent contained in the overcoat layer applied onto the aluminum web 59 evaporates, and thus the overcoat layer in a soft film state turns into a tack-free state.

A heating chamber 15 at the lower end has a similar structure to the heating chamber 14, but as necessary, may be used as a cooling furnace. The heating chamber 15 has an air inlet port 42 and an air exit port 50. A hot-air generator (not shown) is connected to the air inlet port 42 through a duct or the like. A current plate 34 is disposed in the heating chamber 15 between the air inlet port 42 and the aluminum web 59. The current plate 34 has plural slit outlets in opposition to the surface of the aluminum web 59. The current plate 34 rectifies hot air fed from the air inlet port 42 into the heating chamber 15 to cold or hot air currents (cold or hot air) blowing generally perpendicular to the surface of the aluminum web 59.
At that time, hot air is fed to the air inlet port 42 at a rate of 50 to 100 m³/minute for 1 m of width of the aluminum web 59, the temperature of the hot air being adjusted to 25 to 150°C. Through the temperature control, in the heating chamber 15, the temperature on the surface of the image forming layer on the aluminum web 59 may be cooled to 100°C or lower, and about 95% or more of the organic solvent contained in the image forming layer applied onto the aluminum web 59 may evaporate, and thus the overcoat layer turns into a tack-free state.

The aluminum web 59 having formed thereon the image forming layer as described above is wound into a roll by a web winding device 70 to form a stock roll 80. During the formation of the stock roll 80, the aluminum web 59 is wound in such a manner that the image forming layer resides in the outer peripheral surface of the stock roll. Subsequently, the stock roll 80 is fed to the process line (not shown) at intervals established according to the shipment schedule or the like. In the process line, a protective interleaf paper is attached to the aluminum web 59 wound off from the stock roll 80, and then the aluminum web is cut into a predetermined product size by a cutting device. Thus, the production of a planographic printing plate precursor as a final product is completed. The planographic printing plate precursor of the product size is stacked in a predetermined number of sheets by a stacking device provided at the downstream side of the cutting line, and thus a stack of the planographic printing plate is formed. The stack of the planographic printing plate precursor is wrapped and packed with interior wrapping paper such as kraft paper and exterior wrapping paper such as corrugated paper, and arranged for delivery to users.

In the production line 1, the aluminum web 59 having the image forming layer may be directly fed to the process line without being wound into a stock roll, followed by attachment of an interleaf paper and cutting into a predetermined product size in the process line. Also in this case, the planographic printing plate precursor cut into the product size is stacked in a predetermined number of sheets to form a stack of the planographic printing plate, and the stack is wrapped and packed with interior wrapping paper such as kraft paper and exterior wrapping paper such as corrugated paper, and arranged for delivery to users.

In the above-described production line 1 and the process line in which the planographic printing plate precursor is cut, during the transfer of the aluminum web 59 having the image forming layer, the pressure PF acting on the image forming layer on the aluminum web 59 is preferably 1.5 × 10⁵ N/m² or less. In the transfer of the aluminum web 59, the pressure PF is effectively decreased by, for example, enlarging the outside diameter of the transfer roller disposed along the transfer path of the aluminum web 59, or reducing the tension acting on the aluminum web 59. The pressure PF is also effectively reduced by transferring the aluminum web 59 in a non-contact manner.

In the production line 1, when the aluminum web 59 having the image forming layer is wound into a roll to form the stock roll 80, the pressure PR acting on the image forming layer on the aluminum web 59 forming the stock roll 80 is preferably 1.5 × 10⁵ N/m² or less. When the aluminum web 59 is wound, the pressure PR is effectively reduced by, for example, adjusting the winding torque of the winding device 70 so as to reduce the tension of the aluminum web 59 wound into the stock roll 80, or enlarging the inside diameter (outside diameter of the core) of the stock roll 80.

The pressure PR acting on the aluminum web 59 forming the stock roll 80 is kept at the level generated at the time of winding unless the stock roll 80 is directly mounted on a floor or support base and a load force is locally acting on the stock roll 80. More specifically, if the stock roll 80 is supported at the core thereof formed by winding the aluminum web 59, the pressure PR is kept even during storage.

In the process line, when the plural sheets of the planographic printing plate precursor each cut into a product size are stacked by a stacking device, the pressure PP acting on the lowest sheet of the planographic printing plate precursor is preferably 1.5 × 10⁵ N/m² or less. When the sheets of the planographic printing plate precursor are stacked, the pressure PP acting on the image forming layer of the lowest sheet of the planographic printing plate precursor is effectively reduced by, for example, limiting the number of sheets stacked according to the weight of the planographic printing plate precursor per unit area, or stacking the sheets of the planographic printing plate precursor in such a manner that the front and back surfaces of the sheets have an inclination to the horizontal direction. In particular, when plural sheets of the planographic printing plate precursor are stacked in an upright position, theoretically no pressure is acting on the planographic printing plate precursor, or the pressure PP vanishes.

Also during storage of the stack of the predetermined number of sheets of the planographic printing plate precursor, the stack is preferably controlled in such a manner that the pressure PK acting on the image forming layer of the planographic printing plate precursor is 1.5 × 10⁵ N/m² or less. More specifically, control is carried out to avoid piling up plural wrapped stacks of the planographic printing plate precursor, or placing any object on the stack of the planographic printing plate precursor.

### Image forming layer

The image forming layer of the planographic printing plate precursor for use in the invention comprises resin fine particles. The image forming layer of the planographic printing plate precursor for use in the invention preferably comprises an infrared absorbing agent and a polymerization initiator so as to cause polymerization and curing by irradiation with an infrared laser. The image forming layer of the planographic printing plate precursor for use in the invention is preferably removable with a printing ink and/or dampening water.

The resin fine particles comprised in the image forming layer are further described below.

### Resin fine particles

The resin fine particles for use in the invention are at least one selected from thermoplastic polymer fine particles, heat-reactive polymer fine particles, and microcapsules containing a heat-reactive group-containing compound.

Preferable examples of the thermoplastic polymer fine particles used in the invention include thermoplastic polymer fine particles described in Research Disclosure No. 33303, January, 1992, JP-ANos. 9-123387, 9-131850, 9-171249, and 9-171250, and European Patent No. 931647. Specific examples of the polymer fine particles include homopolymers and copolymers of monomers such as ethylene, styrene, vinyl chloride, methyl acrylate, ethyl acrylate, methyl methacrylate, ethyl methacrylate, vinylidene chloride, acrylonitrile, or vinyl carbazole, and mixtures thereof. Among them, more preferable examples include polystyrene and polymethyl methacrylate.

The average particle diameter of the heat-reactive polymer fine particles for use in the invention is preferably 0.01 to 2.0 µm. Examples of the synthesis method for the thermoplastic polymer fine particles include an emulsion polymerization method, a suspension polymerization method, and a dissolution dispersion method in which any one of the above-described compounds is dissolved in a nonaqueous organic solvent, and mixed and emulsified with an aqueous solution having a dispersant, and the emulsion is heated to evaporate the organic solvent so as to solidify the content into particles.

Examples of the thermoplastic polymer fine particles for use in the invention include thermosetting polymer fine particles and polymer fine particles having heat-reactive groups.

Examples of the thermosetting polymers include resins having a phenolic skeleton, urea resins (examples thereof include those made by resinification of urea or an urea compound such as methoxymethylated with an aldehyde such as formaldehyde), melamine resins (examples thereof include those made by resinification of melamine or a melamine compound with an aldehyde such as formaldehyde), alkyd resins, unsaturated polyester resins, polyurethane resins, and epoxy resins. Among them, particularly preferable examples include resins having a phenolic skeleton, melamine resins, urea resins, and epoxy resins.

Preferable examples of the resin having a phenolic skeleton include: phenolic resins made from phenol, cresol, or the like and an aldehyde such as formaldehyde; hydroxystyrene resins; and polymers or copolymers of methacrylamides or acrylamides having a phenolic skeleton and polymers or copolymers of methacrylates or acrylates having a phenolic skeleton such as N-(p-hydroxyphenyl)methacrylamide and p-hydroxyphenyl methacrylate.

The average particle diameter of the thermosetting polymer fine particles for use in the invention is preferably 0.01 to 2.0 µm. The thermosetting polymer fine particles can be easily obtained by a dissolution dispersion method. Alternatively, the fine particles may be produced by particulating the thermosetting polymer during the synthesis thereof. The method for producing the fine particles is not limited to them.

The heat-reactive group of the polymer fine particles having heat-reactive groups for use in the invention may be any reactive functional group as long as it can form a chemical bond. Preferable examples of the group include: ethylenically unsaturated groups capable of radical polymerization reaction (for example, an acryloyl group, a methacryloyl group, a vinyl group, and an allyl group); cationic polymerizable groups (for example, a vinyl group and a vinyloxy group); isocyanate groups or blocked isocyanate groups capable of addition reaction; epoxy groups, vinyloxy groups, and active hydrogen-containing functional groups reacting with these groups (for example, amino groups, hydroxyl groups, and carboxyl groups); carboxyl groups capable of condensation reaction and reaction partners thereof such as hydroxyl groups or amino groups, acid anhydrides capable of ring-opening addition reaction and reaction partners thereof such as amino groups or hydroxyl groups.

Introduction of the functional group into the polymer fine particles may be conducted during polymerization or after polymerization through a polymer reaction.

In cases where the functional group is introduced during polymerization, the above-described monomer having a functional group is preferably subjected to an emulsion polymerization or a suspension polymerization. Specific examples of the monomer having a functional group include allyl methacrylate, allyl acrylate, vinyl methacrylate, vinyl acrylate, 2-(vinyloxy)ethyl methacrylate, p-vinyl oxystyrene, p-{2-(vinyloxy)ethyl}styrene, glycidyl methacrylate, glycidyl acrylate, 2-isocyanateethyl methacrylate, 2-isocyanateethyl methacrylate blocked with an alcohol or the like, 2-isocyanateethyl acrylate, 2-isocyanateethyl acrylate blocked with an alcohol or the like, 2-aminoethyl methacrylate, 2-aminoethyl acrylate, 2-hydroxyethyl methacrylate, 2-hydroxyethyl acrylate, acrylic acid, methacrylic acid, maleic anhydride, bifunctional acrylate, and bifunctional methacrylate.
In addition to the above-described monomers, copolymers of them with monomers which are copolymerizable with the above-described monomers and have no heat-reactive group are also useful in the invention. Examples of the copolymerizable monomer having no heat-reactive group include styrene, alkyl acrylate, alkyl methacrylate, acrylonitrile, and vinyl acetate. The monomer is not limited to the examples as long as it has no heat-reactive group.

Examples of the polymer reaction used for introducing the heat-reactive group into the polymer fine particles after polymerization include the polymer reaction described in WO 96/34316.

Among the polymer fine particles having heat-reactive groups, preferable are those coalesce under heating, and particularly preferable are those having hydrophilic surfaces and being dispersible in water. It is preferable that the contact angle of a film, which is formed by singly applying and drying the polymer fine particles at a temperature which is lower than its coagulation temperature, against a water droplet in air is lower than that of the film prepared through drying at a temperature higher than its coagulation temperature. Examples of the method for hydrophilizing the surfaces of the polymer fine particles include having a hydrophilic polymer or an oligomer such as polyvinyl alcohol or polyethylene glycol, or a hydrophilic low molecular weight compound being absorbed to the surface of the polymer fine particles.

The coagulation temperature of the polymer fine particles having heat-reactive groups is preferably 70°C or more, and more preferably 100°C or more from the viewpoint of temporal stability. The average particle diameter of the polymer fine particles is preferably from 0.01 to 2.0 µm, more preferably from 0.05 to 2.0 µm, and most preferably from 0.1 to 1.0 µm. When the average particle diameter of the polymer fine particles is within the range, a good resolution and good temporal stability are provided.

The microcapsules for use in the invention comprises a heat-reactive group-containing compound in the inside thereof. Examples of the heat-reactive group include the same heat-reactive groups as those used in the polymer fine particles having heat-reactive groups. The heat-reactive group-containing compound is further described below.

Preferable examples of the radical-polymerizable unsaturated group-containing compound include compounds having at least one, preferably two or more ethylenically unsaturated bond(s) such as an acryloyl group, a methacryloyl group, a vinyl group, or an allyl group. Such compounds are widely known as a monomer or a crosslinking agent for polymerizable compositions in the relevant industrial field, and may be for use in the invention without specific limitations. Examples of the chemical form of the compound include a monomer, a prepolymer, more specifically a dimer, a trimer, an oligomer, a polymer or a copolymer, or mixtures thereof.

Specific examples of the radical-polymerizable unsaturated group-containing compound include the compounds having a polymerizable unsaturated group described in JP-A No. 2001-277740. Typical examples of the compounds include trimethylolpropane di(meth)acrylate, trimethylolpropane tri(meth)acrylate, pentaerythritol di(meth)acrylate, pentaerythritol tri(meth)acrylate, pentaerythritol tetra(meth)acrylate, dipentaerythritol di(meth)acrylate, dipentaerythritol penta(meth)acrylate, dipentaerythritol hexa(meth)acrylate, and an adduct of trimethylolpropane diacrylate and xylylene diisocyanate.

Examples of the ethylenically polymerizable unsaturated group-containing polymer or copolymer include copolymers of allyl methacrylate. Specific examples thereof include a copolymer formed of allyl methacrylate and methacrylic acid, a copolymer formed of allyl methacrylate and ethyl methacrylate, and a copolymer formed of allyl methacrylate and butyl methacrylate.

Preferable examples of the vinyloxy group-containing compound for use in the invention include the compounds described in JP-A No. 2002-29162. Specific examples thereof include tetramethyleneglycol divinyl ether, trimethylolpropane trivinyl ether, tetraethyleneglycol divinyl ether, pentaerythritol divinyl ether, pentaerythritol trivinyl ether, pentaerythritol tetravinyl ether, 1,4-bis{2-(vinyloxy)ethyloxy}benzene, 1,2-bis{2-(vinyloxy)ethyloxy}benzene, 1,3-bis{2-(vinyloxy)ethyloxy}benzene, 1,3,5-tris{2-(vinyloxy)ethyloxy}benzene, 4,4'-bis{2-(vinyloxy)ethyloxy}biphenyl, 4,4'-bis{2-(vinyloxy)ethyloxy}diphenyl ether, 4,4'-bis{ 2-(vinyloxy)ethyloxy}diphenyl methane, 1,4-bis{2-(vinyloxy)ethyloxy}naphthalene, 2,5-bis{2-(vinyloxy)ethyloxy}furan, 2,5-bis{2-(vinyloxy)ethyloxy}thiophene, 2,5-bis{2-(vinyloxy)ethyloxy}imidazole, 2,2-bis[4-{2-(vinyloxy)ethyloxy}phenyl] propane, {bis(vinyloxyethyl) ether of bisphenol A}, 2,2-bis{4-(vinyloxymethyloxy)phenyl}propane, and 2,2-bis{4-(vinyloxy)phenyl}propane.

The epoxy group-containing compound for use in the invention preferably has two or more epoxy groups. Examples thereof include glycidyl ether compounds or prepolymers thereof obtained by a reaction between a polyhydric alcohol or polyvalent phenol and epichlorohydrin, and polymers or copolymers of glycidyl acrylate or glycidyl methacrylate.

Specific examples of the epoxy group-containing compound include propylene glycol diglycidyl ether, tripropylene glycol diglycidyl ether, polypropylene glycol diglycidyl ether, neopentyl glycol diglycidyl ether, trimethylolpropane triglycidyl ether, a diglycidyl ether of hydrogenated bisphenol A, hydroquinone diglycidyl ether, resorcinol diglycidyl ether, a diglycidyl ether or epichlorohydrin polyadduct of bisphenol A, a diglycidyl ether or epichlorohydrin polyadduct of bisphenol F, a diglycidyl ether or epichlorohydrin polyadduct of halogenated bisphenol A, a diglycidyl ether or epichlorohydrin polyadduct of biphenyl-type bisphenol, glycidyl etherification products of novolak resins, copolymers formed of methyl methacrylate and glycidyl methacrylate, and copolymers formed of ethyl methacrylate and glycidyl methacrylate.

Examples of commercially available products of the above-described compounds include EPICOAT 1001 (molecular weight, about 900; epoxy equivalent weight, 450 to 500), EPICOAT 1002 (molecular weight, about 1,600; epoxy equivalent weight, 600 to 700), EPICOAT 1004 (molecular weight, about 1,060; epoxy equivalent weight, 875 to 975), EPICOAT 1007 (molecular weight, about 2,900; epoxy equivalent weight, 2,000), EPICOAT 1009 (molecular weight, about 3,750; epoxy equivalent weight, 3,000), EPICOAT 1010 (molecular weight, about 5,500; epoxy equivalent weight, 4,000), EPICOAT 1100L (epoxy equivalent weight, 4,000) and EPICOAT YX31575 (epoxy equivalent weight, 1,200), all of which are manufactured by Japan Epoxy Resins Co., Ltd.; and SUMIEPOXY ESCN-195XHN, ESCN-195XL and ESCN-195XF, all of which are manufactured by Sumitomo Chemical Co., Ltd.

Preferable examples of the isocyanate compound for use in the invention include tolylene diisocyanate, diphenylmethane diisocyanate, polymethylene polyphenyl polyisocyanate, xylylene diisocyanate, naphthalene diisocyanate, cyclohexanephenylene diisocyanate, isophorone diisocyanate, hexamethylene diisocyanate, cyclohexyl diisocyanate, and compounds obtained by blocking these with an alcohol or amine.

Examples of the amine compound preferred in the invention include ethylenediamine, diethylenetriamine, triethylenetetraamine, hexamethylenediamine, propylenediamine, and polyethyleneimine.

Examples of the hydroxyl group-containing compound preferred in the invention include compounds having terminal methylol groups, polyols such as pentaerythritol, bisphenols, and polyphenols.

Examples of the carboxyl group-containing compound preferred in the invention include aromatic polycarboxylic acids such as a pyromellitic acid, a trimellitic acid or a phthalic acid, and aliphatic polycarboxylic acids such as an adipic acid.

Examples of the acid anhydride preferred in the invention include pyromellitic anhydride and benzophenonetetracarboxylic anhydride.

Examples of the method for microencapsulating the heat-reactive group-containing compound include known methods. Example of the method for preparing microcapsules include, but not limited to, a method using coacervation as described in U.S. Patent Nos. 2,800,457 and 2,800,458, a method using interfacial polymerization as described in U.S. Patent No. 3,287,154, JP-B Nos. 38-19574 and 42-446, a method using polymer deposition as described in U.S. Patent Nos. 3,418,250 and 3,660,304, a method using an isocyanate polyol wall material as described in U.S. Patent No. 3,796,669, a method using an isocyanate wall material as described in U.S. Patent 3,914,511, a method of using an urea-formaldehyde-based or urea formaldehyde-resorcinol-based wall forming material as described in U.S. Patent Nos. 4,001,140, 4087376, and 4,089,802, a method of using a wall material such as a melamine-formaldehyde resin or hydroxy cellulose as described in U.S. Patent No. 4025445, an in situ method of using monomer polymerization as described in JP-B Nos. 36-9163 and 51-9079, a spray drying method as described in U.K. Patent No. 930422 and U.S. Patent No. 3,111,407, and an electrolysis dispersion cooling method as described in U.K. Patent Nos. 952807 and 967074.

It is preferable that the wall of the microcapsules for use in the invention has a three-dimensional crosslinked structure and is swelled by a solvent. From such viewpoints, preferable examples of the wall material of the microcapsules include polyurea, polyurethane, polyester, polycarbonate, polyamide, and mixtures thereof, and particularly preferable examples thereof include polyurea and polyurethane. The microcapsule wall may have a heat-reactive group-bearing compound introduced therein.

The average particle diameter 1 of the microcapsules is preferably from 0.01 to 3.0 µm, more preferably from 0.05 to 2.0 µm, and particularly preferably from 0.10 to 1.0 µm. When the average particle diameter 1 of the microcapsules is within the range, a good resolution and good stability with lapse of time are provided.

The microcapsules may or may not mutually coalesce under heating. More specifically, it is only necessary that the content of the microcapsules exude to the surface or outside of the microcapsules, or enter into the microcapsule wall, and cause a chemical reaction under heating. The content may react with an additional hydrophilic resin or low molecular weight compound. Alternatively, two or more kinds of microcapsules may be reacted with each other through differing heat-reactive functional groups. Accordingly, it is desirable, though not essential, for good image formation that the microcapsules melt and coalesce with each other under heating.

Among the resin fine particles for use in the invention, more preferable are heat-reactive polymer fine particles and microcapsules containing a heat-reactive group-containing compound, and further preferable are polymer fine particles having heat-reactive groups and microcapsules containing a polymerizable compound.

The amount of the polymer fine particles or microcapsules added to the image forming layer is preferably 50% by mass or more, more preferably from 70% to 98% by mass or more with respect to the solid content of the image forming layer in terms of the solid content. When the addition amount is within the range, good image formation is achieved, and good printing durability is provided.

In cases where the microcapsules are included in the image forming layer of the invention, a solvent which dissolves the content of the microcapsules and swells the microcapsule wall may be added to the medium for dispersing the microcapsules. The solvent induces the heat-reactive group-containing compound in the microcapsules to diffuse out of the microcapsules. The solvent may be easily selected from many commercial available solvents with depending on the microcapsule dispersion medium, the material and thickness of the microcapsule wall, and the content of the microcapsules. In a case where the microcapsules are water-dispersible microcapsules composed of a crosslinked polyurea or polyurethane wall, preferable examples of the solvent include alcohols, ethers, acetals, esters, ketones, polyhydric alcohols, amides, amines, and fatty acids.

Specific examples thereof include, but not limited to, methanol, ethanol, tertiary butanol, n-propanol, tetrahydrofuran, methyl lactate, ethyl lactate, methyl ethyl ketone, propylene glycol monomethyl ether, ethylene glycol diethyl ether, ethylene glycol monomethyl ether, γ-butyllactone, N,N-dimethylformamide, and N,N-dimethylacetamide. These solvents may be used in combination of two or more of them. Also useful is a solvent which does not dissolve in a microcapsule dispersion liquid but dissolves in a mixture of the microcapsule dispersion liquid and any of the above-described solvents.

While the addition amount of the solvent is determined according to the combination of the materials, the effective amount is generally from 5 to 95% by mass with reference to the coating liquid. A preferable range thereof is from 10 to 90% by mass, and a more preferable range is from 15 to 85% by mass.

### EXAMPLES

The production method and handling method for a planographic printing plate precursor according to the invention is illustrated in more detail with reference to examples.

### 1. Production of planographic printing plate precursor

### (1) Production of support

An aluminum plate having a thickness of 0.3 mm (Al: 99.50% or more, Si: 0.25%, Fe: 0.40%, Cu: 0.05%, Mn: 0.05%, Mg: 0.05%, Zn: 0.05%, Ti: 0.03%) was degreased with a 10% by mass aqueous solution of sodium aluminate at 50°C for 30 seconds to remove the rolling oil on the surface, and the aluminum surface was grained with three nylon brushes having bristles of 0.3 mm diameter and a pumice-water suspension having a median diameter of 25 µm (specific gravity: 1.1 g/cm³), and then thoroughly washed with water. The plate was etched by being immersed in a 25% by mass aqueous solution of sodium hydroxide at 45°C for 9 seconds. After washing with water, the plate was further immersed in a 20% by mass nitric acid at 60°C for 20 seconds, and then washed with water. The etching amount of the grained surface was about 3 g/m².

Subsequently, the plate was subjected to electrochemical surface-roughening treatment using a 60-Hz AC voltage in a continuous manner. The electrolytic solution used in the surface-roughening treatment was 1 % by mass aqueous solution of nitric acid (containing 0.5% by mass of aluminum ions), and the liquid temperature was 50°C. The alternating current power source waveform used was one providing a trapezoidal rectangular wave alternating current in which the time required for the current value to increase from zero to a peak was 0.8 msec and the duty ratio was 1:1. A carbon electrode was used as a counter electrode, and ferrite was used for an auxiliary anode. 50% of the current flowing from the power source was supplied to the auxiliary anode. The quantity of electricity during the nitric acid electrolysis was 175 C/dm² in terms of the sum of electricity at the time when the aluminum plate was functioning as an anode. After the surface-roughening treatment, the aluminum plate was washed by water spraying.

Subsequently, the aluminum plate was subjected to electrochemical surface-roughening treatment in a similar manner as nitric acid electrolysis except that an electrolytic solution was a 0.5% by mass aqueous solution of hydrochloric acid (containing 0.5% by mass of aluminum ions) having a liquid temperature of 50°C and the quantity of electricity was 50 C/dm² at the time when the aluminum plate was functioning as an anode. Thereafter, the aluminum plate was washed by water spraying. The aluminum plate was electrolyzed in a 15% by mass sulfuric acid (containing 0.5% by mass of aluminum ions) at an electric current density of 15 A/dm² to form a direct current anodized film of 2.5 g/m², and then washed with water, dried, and thus a support (aluminum web) A was obtained. The center line average roughness (Ra) of the support was measured using a needle having a diameter of 2 µm, and found to be 0.51 µm.

### (2) Preparation of undercoat layer coating liquid

The following ingredients were mixed to prepare an undercoat layer coating liquid.
Composition of undercoat layer coating liquid
Undercoat compound: 0.017 g
Methanol 9.00 g
Water 1.00 g

Undercoat compound (1)

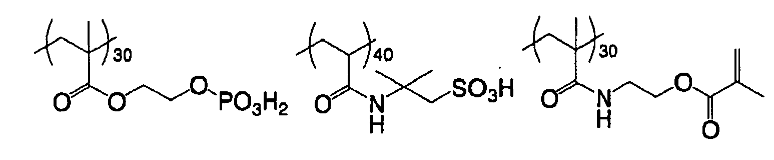

### (3) Synthesis of thermoplastic polymer fine particles (fine particles A)

15g of styrene was added to 200 ml of aqueous solution of polyoxyethylene phenol (concentration: 9.84 × 10⁻³ moll⁻¹), and the mixture was stirred at 250 rpm under nitrogen purge. The temperature of the solution was adjusted to 25°C, and then the solution was mixed with 10 ml of an aqueous solution of cerium (IV) ammonium salt (concentration 0.984 × 10⁻³ mol/l). At that time, the pH of the solution was adjusted to 1.3 to 1.4 with an aqueous solution of ammonium nitrate (concentration 58.8 × 10⁻³ mol/l). Thereafter, the solution was stirred for 8 hours. The solids content of the thus obtained solution was 9.0% by mass, and the average particle diameter of the thermoplastic polymer fine particles in the solution as measured with a particle diameter distribution analyzer (trade name: LA-910, manufactured by Horiba, Ltd.) was 0.4 µm.

### (4) Synthesis of polymer fine particles having heat-reactive functional groups (fine particles B)

7.5 g of allyl methacrylate and 7.5 g of butyl methacrylate were added to 200 ml of an aqueous solution of polyoxyethylene nonylphenol (concentration: 9.84 × 10⁻³ moll⁻¹), and the mixture was stirred at 250 rpm under nitrogen purge. The temperature of the solution was adjusted to 25°C, and then the solution was mixed 1.0 ml of an aqueous solution of cerium (IV) ammonium salt (concentration: 0.984 × 10⁻³ moll⁻¹). At that time, the pH of the solution was adjusted to 1.3 to 1.4 with an aqueous solution of ammonium nitrate (concentration: 58.8 × 10⁻³ moll⁻¹). Thereafter, the solution was stirred for 8 hours. The solids content of the thus obtained solution was 9.5% by mass, and the average particle diameter of the thermoplastic polymer fine particles in the solution as measured with a particle diameter distribution analyzer (trade name: LA-910, manufactured by Horiba, Ltd.) was 0.4 µm.

### (5) Synthesis of microcapsules containing a polymerizable compound (fine particles C)

As an oil phase component, 10 g of an trimethylolpropane adduct with xylene diisocyanate (trade name: TAKENATE D-110N, manufactured by Mitsui Takeda Chemicals, Inc., 75% by mass solution in ethyl acetate), 6.00 g of ARONIX M-215 (manufactured by Toagosei Co., Ltd.), and 0.18 g of PIONIN A-41C (manufactured by Takemoto Oil & Fat Co., Ltd.) were dissolved in 16.61 g of ethyl acetate. As an aqueous phase component, 37.5 g of a 4% by mass aqueous solution of PVA-205 was prepared. The oil phase component and the aqueous component were mixed, and emulsified at 12,000 rpm for 10 minutes using a homogenizer. The thus obtained emulsion was added to 23 g of distilled water, stirred at room temperature for 30 minutes, and then stirred at 40°C for 2 hours. The thus obtained microcapsule liquid was diluted with distilled water to adjust the solid content thereof to 15% by mass. The average particle diameter of the microcapsules as measured with a particle diameter distribution analyzer (trade name: LA-910, manufactured by Horiba, Ltd.) was 0.2 µm.

### (6) Preparation of image forming layer coating liquid

The ingredients were dissolved or dispersed in a solvent according to each of the following formulae of the coating liquid to prepare an image forming layer coating liquid (image forming layer coating liquid A or image forming layer coating liquid B). The image forming layer coating liquid C was prepared as follows: an organic solvent-containing liquid and an aqueous solvent-containing liquid having the following compositions were independently prepared, and then the aqueous solvent-containing liquid was added to the organic solvent-containing liquid under stirring, and the stirring operation was stopped 15 minutes after the addition.

### (a) Image forming layer coating liquid A [image forming layer coating liquid having fine particles A]

Synthesized thermoplastic polymer fine particles (9% by mass aqueous solution): 68.8 g
Infrared absorbing agent (1): 0.3 g
Polyhydroxyethyl acrylate (Weight average molecular weight 25,000): 0.5 g
1-methoxy-2-propanol: 30.3 g

Infrared absorbing agent (1)

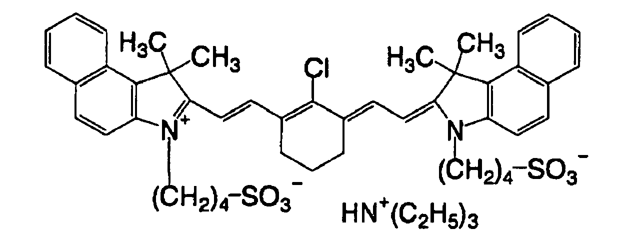

### (b) Image forming layer coating liquid B [image forming layer coating liquid having fine particles B]

Synthesized polymer fine particles having heat-reactive functional groups (9% by mass aqueous solution): 54.8 g
Infrared absorbing agent (1): 0.3 g
Polymerization initiator: 0.2 g
Polymerizable compound ARONIX M-215 (manufactured by Toagosei Co., Ltd.): 1.0 g
Polyhydroxyethyl acrylate (weight average molecular weight 25,000): 0.5 g
1-methoxy-2-propanol: 44.0 g

### (c) Image forming layer coating liquid C [image forming layer coating liquid having fine particles C]

Organic solvent-containing liquid:
Infrared absorbing agent (2): 0.2 g
Polymerization initiator (1): 1.0 g
Binder polymer (1) (weight average molecular weight 80,000): 1.6 g
Polymerizable compound ARONIX M-215 (manufactured by Toagosei Co., Ltd.): 3.9 g
Propylene glycol monomethyl ether: 86.1 g
Methyl ethyl ketone: 11.0 g
Aqueous solvent-containing liquid:
Microcapsules containing a polymerizable compound (1): 26.5 g
Distilled water: 47.1 g
Fluorine surfactant (1): 0.05 g

Binder polymer (1)

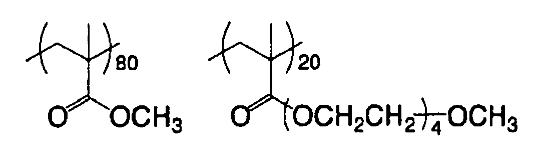

Polymerization initiator (1)

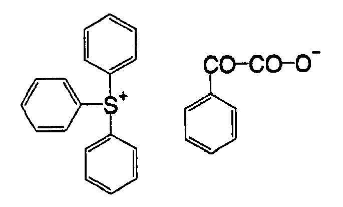

Infrared absorbing agent (2)

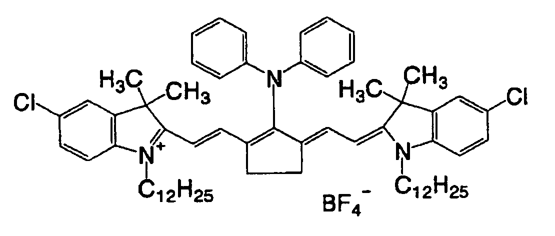

Fluorine surfactant (1)

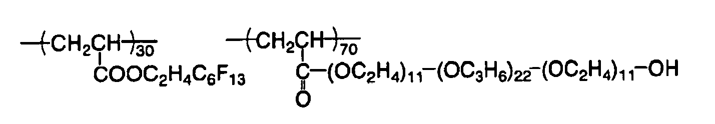

### (7) Preparation of overcoat layer coating liquid

The following ingredients were mixed and dissolved to prepare an overcoat layer coating liquid A.
Overcoat layer coating liquid A
PVA 105 (manufactured by Kuraray Co., Ltd.): 5.37 g
Polyvinylpyrrolidone: 0.05 g
EMALEX 710 (nonionic surfactant, manufactured by Kao Corporation): 0.43 g
Swelling mica aqueous dispersion (trade name: SOMASIF MEB-3L, manufactured by Co-op Chemical Co., Ltd.): 15.00 g
Water 54.15 g

### (8) Drying conditions and transfer speed of planographic printing plate precursor

Using the production line shown in Fig. 1, a planographic printing plate precursor was produced under the following production conditions (i) and (ii).
(i) Conditions for drying image forming layer coating liquid in drying furnace
   Air blowing direction: Vertical airflow
   Nozzle slit width: 2 mm
   Nozzle pitch: 150 mm
   Nozzle wind speed: 10 m/second
(ii) Transfer speed of aluminum web: 100 m/minute

### EXAMPLE 1

Using the production line shown in Fig. 1, the undercoat layer coating liquid shown in the above (2) was applied onto the support (aluminum web) shown in the above (1), dried, and then the image forming layer coating liquid A, B, or C was applied onto the aluminum web, dried under the conditions summarized in (Table 1), and thus the planographic printing plate precursors were produced. In Table 1, PL is the liquid pressure of the image forming layer coating liquid in the puddle formed between the aluminum web and the coating member, and τ is the shear stress (maximum value) acting on the puddle formed between the aluminum web and the coating member. PF is the pressure (maximum value) acting on the image forming layer on the aluminum web when the aluminum web having the image forming layer is transferred.

The on-machine developability was evaluated according to the following evaluation method.

### Evaluation of printing

Each of the planographic printing plate precursors obtained above was subjected to light using an exposure apparatus (trade name: TRENDSETTER 3244 VX, manufactured by Creo Products, Inc.) equipped with a water-cooled 40 W infrared semiconductor laser with an output power of 9 W, an external drum rotation speed of 210 rpm, and a resolution of 2400 dpi. Each of the exposed precursor was mounted on the cylinder of a printing machine (trade name: SPRINT 25, manufactured by Komori Corporation) without being subjected to any development treatment. A 4% by weight aqueous solution of dampening water (trade name: IF 102, manufactured by Fuji Photo Film Co., Ltd.) and a black ink (trade name: TRANS-G(N), manufactured by Dainippon Ink And Chemicals, Incorporated) were supplied to each of the precursors, and then printing was conducted at a printing speed of 8,000 sheets per minute. The on-machine developabilities of the precursors was evaluated in terms of the number of sheets printed by the time when a good printed sheet was obtained.

**Table 1**

| Run No. | Application method | PL (kPa) | τ (kPa) | PL + τ (kPa) | PF (kPa) | On-machine developability (sheets) | | |
|---|---|---|---|---|---|---|---|---|
| | | | | | | Coating liquid A | Coating liquid B | Coating liquid C |
| 1 | Bar | 60 | 0.03 | 60.03 | 60 | 15 | 15 | 10 |
| 2 | Bar | 150 | 0.03 | 150.03 | 150 | 65 | 65 | 65 |
| 3 | Bar | 60 | 0.03 | 60.03 | 160 | 70 | 70 | 70 |
| 4 | Bar | 60 | 0.03 | 60.03 | 150 | 25 | 20 | 20 |
| 5 | Bar | 140 | 0.03 | 140.03 | 150 | 25 | 20 | 20 |
| 6 | Extrusion | 60 | 0.05 | 60.05 | 150 | 25 | 20 | 20 |
| 7 | Extrusion | 60 | 0.05 | 60.05 | 160 | 70 | 70 | 70 |
| 8 | Slide bead | 60 | 0.06 | 60.06 | 150 | 25 | 20 | 20 |
| 9 | Slide bead | 60 | 0.06 | 60.06 | 160 | 70 | 70 | 70 |
| 10 | Roll | 60 | 0.08 | 60.08 | 60 | 15 | 15 | 10 |
| 11 | Roll | 60 | 0.03 | 60.03 | 160 | 70 | 70 | 70 |
| 12 | Roll | 150 | 0.03 | 150.03 | 150 | 65 | 65 | 65 |
| 13 | Roll | 60 | 0.03 | 60.03 | 150 | 25 | 25 | 20 |
| 14 | Bar | 5 | 0.03 | 5.03 | 150 | Problematic surface properties | | |
| 15 | Bar | 40 | 0.03 | 40.03 | 150 | Problematic surface properties | | |
| 16 | Bar | 50 | 0.03 | 50.03 | 150 | 20 | 20 | 15 |

As is clearly shown in Table 1, planographic printing plate precursors produced under conditions having a PL of 0.5 × 10⁵ N/m² or more and less than 1.5 × 10⁵ N/m², a PL + τ of 0.5 × 10⁵ N/m² or more and 1.5 × 10⁵ N/m² or less, and a PF of 1.5 × 10⁵ N/m² or less (Run Nos. 1, 4 to 6, 8, 10, and 15) showed good results of the printing evaluation.

However, when any of the PL, PL + τ, and PF was greater than 1.5 × 10⁵ N/m² (Run Nos. 2 to 3, 7, 9, 8, and 11 to 12), the results of the printing evaluation rapidly decreased as the increase in the pressure acting on the image forming layer.

On the other hand, when the PL and PL + τ of the planographic printing plate precursors were not greater than 0.5 × 10⁵ N/m² (Run Nos. 14 and 15), unevenness (surface roughness) deviating from the quality standard occurred on the surface of the image forming layer which had been applied to and dried on the aluminum web. This is considered due to that, in the continuous application of the image forming layer coating liquid on the aluminum web, the liquid pressure in the puddle formed between the aluminum web and the coating member was too low to achieve intended high speed thin layer coating aptitude. The high speed thin layer coating aptitude means the property of stably applying an amount of 25 cc/m² or less onto a support at a line speed of 60 m/min.

### EXAMPLE 2

A planographic printing plate precursor produced under the conditions in Example 1 (Run No.1) was stored under the conditions summarized in Table 2, and the on-machine developability of the planographic printing plate precursor was evaluated. The on-machine developability was evaluated in the same manner as Example 1.

In Table 2, PR is the pressure (maximum value) acting on the image forming layer on the planographic printing plate precursor wound into a stock roll before being cut into a product size.

PP is the pressure (maximum value) acting on the image forming layer on the planographic printing plate precursor forming a stack of plural sheets of the planographic printing plate precursor cut into a product size. The pressure PP is usually acting on the image forming layer of the planographic printing plate precursor at the bottom of the stack.

In Table 2, the planographic printing plate precursors of Run Nos. 1 to 3 and 10 were stored in the form of a stock roll, and not stored in the form of a stack; the planographic printing plate precursors of Run Nos.4 to 6 and 11 were stored in the form of a stack, and not stored in the form of a stock roll; the planographic printing plate precursors of Run Nos. 7 to 10, and 12 to 14 were stored in the form of a stock roll, and subsequently stored in the form of a stack.

**Table 2**

| Run No. | Pressure during storage | | On-machine developability (number of sheets) | | |
|---|---|---|---|---|---|
| | PR (kPa) | PP (kPa) | Coating liquid A | Coating liquid B | Coating liquid C |
| 1 | 60 | - | 15 | 15 | 10 |
| 2 | 140 | - | 25 | 20 | 20 |
| 3 | 160 | - | 70 | 70 | 70 |
| 4 | - | 60 | 15 | 15 | 10 |
| 5 | - | 140 | 25 | 20 | 20 |
| 6 | - | 160 | 70 | 70 | 70 |
| 7 | 60 | 60 | 15 | 15 | 10 |
| 8 | 160 | 60 | 70 | 70 | 70 |
| 9 | 60 | 160 | 70 | 70 | 70 |
| 10 | 150 | - | 25 | 25 | 25 |
| 11 | - | 150 | 25 | 25 | 25 |
| 12 | 150 | 60 | 25 | 25 | 25 |
| 13 | 60 | 150 | 25 | 25 | 25 |
| 14 | 150 | 150 | 25 | 25 | 25 |

As is clearly shown in Table 2, good printing results were obtained when the pressure PR acting on the image forming layer on the planographic printing plate precursor forming a stock roll before cutting was 1.5 × 10⁵ N/m² or less (Run Nos. 1 to 2, and 10), when the pressure acting on the image forming layer on the planographic printing plate precursor after cutting and forming a stack was 1.5 × 10⁵ N/m² or less (Run Nos.4 to 5, and 11), and when the pressure PR acting on the image forming layer on the planographic printing plate precursor forming a stock roll before cutting was 1.5 × 10⁵ N/m² or less and the pressure acting on the image forming layer on the planographic printing plate precursor after cutting and forming a stack was 1.5 × 10⁵ N/m² or less (Run Nos. 7 and 12 to 13). On the other hand, when either of the pressures PR and PP exceeded (Run Nos. 3, 6, 8 to 9), the printing results rapidly degraded.

## Claims

1. A method for producing and handling a planographic printing plate precursor, comprising: applying, onto a support, a coating liquid comprising a photosensitive composition having fine particles dispersed therein by using a coating member; and drying the coating liquid to form an image forming layer, wherein a pressure acting on the image forming layer during or after formation of the image forming layer is 1.5 × 10⁵ N/m² or less.

2. The method of claim 1, wherein PL, which is a pressure acting on the coating liquid intervening between the coating member and the support during application of the coating liquid, is at least 0.5 × 10⁵ N/m² and less than 1.5 × 10⁵ N/m².

3. The method of claim 1 or 2, wherein the sum of the pressure PL and a shear stress τ during the application of the coating liquid is at least 0.5 × 10⁵ N/m² and 1.5 × 10⁵ N/m² or less.

4. The method of any one of claims 1 to 3, further comprising transferring the support having the image forming layer formed thereon, and PF, which is a pressure acting on the image forming layer during the transfer of the support, is 1.5 × 10⁵ N/m² or less.

5. The method of any one of claims 1 to 4, further comprising winding the support, which is in the form of a long strip, together with the image forming layer into a stock roll and winding off the support from the stock roll so as to cut the support together with the image forming layer, wherein the support is wound into a roll in such a manner that PR, which is a pressure acting on the image forming layer on the support forming the stock roll during the winding of the support, is 1.5 × 10⁵ N/m² or less.

6. The method of any one of claims 1 to 5, further comprising stacking a plurality of sheets of the planographic printing plate precursor, wherein PP, which is a pressure acting on the image forming layer on the planographic printing plate precursor during the stacking, is 1.5 × 10⁵ N/m².

7. The method of any one of claims 1 to 6, further comprising winding the support, which is in the form of a long strip, together with the image forming layer into a stock roll and storing the stock roll, wherein PK, which is a pressure acting on the image forming layer on the support forming the stock roll during the storing, is 1.5 × 10⁵ N/m² or less.

8. The method of any one of claims 1 to 7, wherein the fine particles are polymer fine particles.
